# EUROPÄISCHE PATENTANMELDUNG

(11) **EP 1 005 160 A2**
(43) Veröffentlichungstag der Anmeldung: **31.05.2000**
(21) Anmeldenummer: 99122732.3
(22) Anmeldetag: 16.11.1999
(51) Int. Cl.: H03K 17/567, H03K 17/687

(54) **Schaltungseinrichtung für einen elektronischen Leistungsschalter**

(30) Priorität: 28.11.1998 DE 19855054
(71) Anmelder: EGO Control Systems GmbH + Co. KG, 72336 Balingen (DE)
(72) Erfinder: Manan Canellas, José Antonio, 08125 Montoada i Reixac, Barcelona (ES)
(74) Vertreter: Patentanwälte Ruff, Beier, Schöndorf und Mütschele

(57) **Zusammenfassung**

Die Erfindung schafft eine Schaltungseinrichtung mit einer Pegelveränderungseinrichtung und einem Treiber für elektronische Leistungsschalter (12), insbesondere IGBT's oder Leistungs-MOS-Transistoren, mit denen eine Last (14) betrieben wird. Sie kann einen Signal-Transistor (21) (NPN) aufweisen, dessen Basis mit dem positiven Anschluß einer Spannungsversorgung (22) für ein logisches Eingangssignal verbunden ist, welches von einer Schaltlogik (23) über einen Festwiderstand (25) an den Emitter des Signal-Transistors (21) gegeben wird. Dabei ist dessen Kollektor über einen Widerstand (27) mit dem positiven Anschluß einer frei flottierenden Hilfsstromversorgung (28) verbunden. Der Transistor (21) kann durch ein an seinen Emitter gegebenes Low-Signal aktivierbar sein und steuert einen Treiber (17) für den Leistungsschalter (12). Der Treiber (17) kann einen PNP-Transistor (34) in Emitterschaltung sowie an seinem Kollektor eine Emitterfolgeschaltung eines NPN-Transistors (35) und eines PNP-Transistors (36) aufweisen.

## Beschreibung

### ANWENDUNGSGEBIET UND STAND DER TECHNIK

Die Erfindung betrifft eine Schaltungseinrichtung mit einer Pegelveränderungseinrichtung und einem Treiber für einen elektronischen Leistungsschalter, mit dem eine Last betrieben wird. Derartige elektronische Leistungsschalter können insbesondere IGBT's oder Leistungs-MOS-Transistoren sein. Eine Last kann insbesondere induktiver Art sein, vorzugsweise eine Induktionsspule.

Elektronische Leistungsschalter werden heutzutage in vielen Bereichen der Elektronik, der Leistungselektronik sowie der Steuerungstechnik eingesetzt. Sie können auf verschiedene Arten betrieben werden, in den meisten Fällen mit hohen Schaltfrequenzen, insbesondere bei Puls-Weiten-Modulation, wobei die Schaltfrequenzen bis in den nicht mehr vom Menschen wahrnehmbaren Frequenzbereich reichen können. Dafür geeignete Treiber müssen bestimmte Bedingungen wie hohe Geschwindigkeit, hohe Rauschunterdrückung, vorhersehbare und stabile Schaltverzögerungen und dergleichen erfüllen. In vielen Fällen werden Treiber mit einem Differential-Signalausgang benötigt.

Es wurden verschiedene Lösungen für Treiber entwickelt, wie beispielsweise optogekoppelte Treiber, integrierte Schaltkreise als Halbbrückentreiber bis hin zu dreiphasigen Vollbrückentreibern mit sechs einzelnen Gattertreibern in einem integrierten Schaltkreis. Die Kosten für diese Vorschläge können die Kosten für die Leistungsschalter übersteigen und den Anwendungsbereich limitieren. Ältere Konzepte mit einer Pulstransformation sind sehr aufwendig und nicht ausreichend leistungsfähig.

### AUFGABE UND LÖSUNG

Der Erfindung liegt die Aufgabe zugrunde, eine oben beschriebene Schaltungseinrichtung zu schaffen, die einfach aufgebaut ist und dennoch effektiv arbeitet sowie kostengünstig herstellbar ist.

Gelöst wird diese Aufgabe durch die Merkmale des Anspruchs 1. Vorteilhafte Ausgestaltungen der Erfindung sind Gegenstand der Unteransprüche. Erfindungsgemäß weist die Schaltungseinrichtung einen Signal-Transistor auf, vorzugsweise einen NPN-Transistor, dessen Basis mit dem positiven Anschluß einer Spannungsversorgung für eine Schaltlogik zur Erzeugung eines logischen Eingangssignals verbunden ist, wobei das logische Eingangssignal von der Schaltlogik über einen Festwiderstand an den Emitter des Signal-Transistors gegeben wird. Dessen Kollektor ist über einen Widerstand mit dem positiven Anschluß einer Hilfsstromversorgung verbunden. Die Schaltlogik ist vorteilhaft Teil der Pegelveränderungseinrichtung. Bevorzugt werden für die Schaltung im wesentlichen diskrete Bauteile benutzt.

Die Hilfsstromversorgung kann frei flottierend sein. Frei flottierend bedeutet in diesem Zusammenhang erdfrei, also daß eine Stromquelle bzw. ein Schaltungsbestandteil erdfrei ist und nicht gegen Erde geht.

In weiterer Ausgestaltung der Erfindung können ein Spannungskomparator und ein Treiber als Verstärker vorgesehen sein, die beide an die Hilfsstromversorgung angeschlossen sind. Der Treiber steuert den Leistungsschalter an bzw. ist mit dessen Gatter verbunden, insbesondere über einen weiteren Widerstand. Der Eingang des Treibers ist vorteilhaft mit dem Kollektor des Signal-Transistors verbunden. In weiterer Ausgestaltung kann der Treiber selber frei flottierend sein.

Bevorzugt ist die Schaltlogik ein Baustein mit negativer Logik. Sie kann in CMOS- oder Bipolartechnologie ausgeführt sein, wobei eine Push-Pull-Konfiguration, eine mit einem offenen Kollektor oder einem offenen Drain-Anschluß verwendet werden kann. Eine Möglichkeit ist ein Mikrokontroller. Der Signal- bzw. NPN-Transistor kann durch ein über den Festwiderstand an seinen Emitter gegebenes Signal der Schaltlogik aktiviert werden, wobei aufgrund der negativen Logik der Schaltlogik eine Aktivierung durch ein LOW-Signal erfolgt.

Mit dem Leistungsschalter können verschiedene Arten von Lasten betrieben werden. Vorteilhaft ist die von einem oder mehreren elektronischen Leistungsschaltern betriebene Last eine Induktionsspule, beispielsweise als Energieversorgung eines Induktionskochfeldes oder eine Spule eines elektronisch kommutierten Motors. Des weiteren können Lasten einfach an eine Versorgung durchgeschaltet werden.

Die Schaltungseinrichtung kann wenigstens paarweise implementiert sein um jeweils zwei gleiche Leistungsschalter in Brückenschaltung anzusteuern, welche über eine Gleichspannungsquelle gelegt sind. Bei einem Ausführungsbeispiel ist der Kollektor des ersten Leistungsschalters mit dem positiven Anschluß der Gleichspannungsquelle verbunden, sein Emitter wiederum mit dem Kollektor des zweiten Leistungsschalters und dessen Emitter ist mit dem negativen Anschluß der Gleichspannungsquelle verbunden. Die zu betreibende Last ist mit dem Emitter des ersten bzw. dem Kollektor des zweiten Leistungsschalters verbunden. In ähnlicher Weise können Mehrfachpaare dieser Art gebildet werden, um Mehrfachpaare von Leistungsschaltern zu betreiben.

Gemäß einer Ausgestaltung der Erfindung kann der Treiber einen PNP-Transistor in Emitterschaltung mit einem Pull-Down-Widerstand am Kollektor aufweisen. Der Kollektor ist vorteilhaft mit den Basen zweier komplementärer NPN- und PNP-Transistoren in Emitterfolgeschaltung verbunden. Deren gemeinsamer Ausgang wiederum bildet den Ausgang des Treibers und steuert über einen Widerstand den Leistungsschalter an.

Der Verstärker kann einen Kondensator und eine Diode aufweisen, wobei deren Kathode mit dem positiven Anschluß einer Spannungsversorgung verbunden ist. Die Spannungsversorgung kann insbesondere gegen Erde gelegt sein.

Eine erfindungsgemäße Schaltungseinrichtung kann vorteilhaft zur Modulation von Pulsen bei hohen Spannungen geeignet sein, wobei diese Spannung durch Glätten einer Versorgungsspannung, beispielsweise aus dem öffentlichen Versorgungsnetz, erzeugt werden kann.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränkt die unter diesen gemachten Aussagen nicht in ihrer Allgemeingültigkeit.

### KURZBESCHREIBUNG DER ZEICHNUNGEN

In den Zeichnungen werden Ausführungsbeispiele der Erfindung dargestellt und im folgenden erläutert. In den Zeichnungen zeigen:
- Fig. 1: eine Schaltungseinrichtung mit frei flottierendem Treiber, der einen Leistungsschalter ansteuert,
- Fig. 2: eine Ausführungsmöglichkeit für einen Treiber gemäß Fig. 1 und
- Fig. 3: eine Brückenschaltung zweier Leistungsschalter, mit denen eine induktive Last betrieben wird.

### BESCHREIBUNG DER AUSFÜHRUNGSBEISPIELE

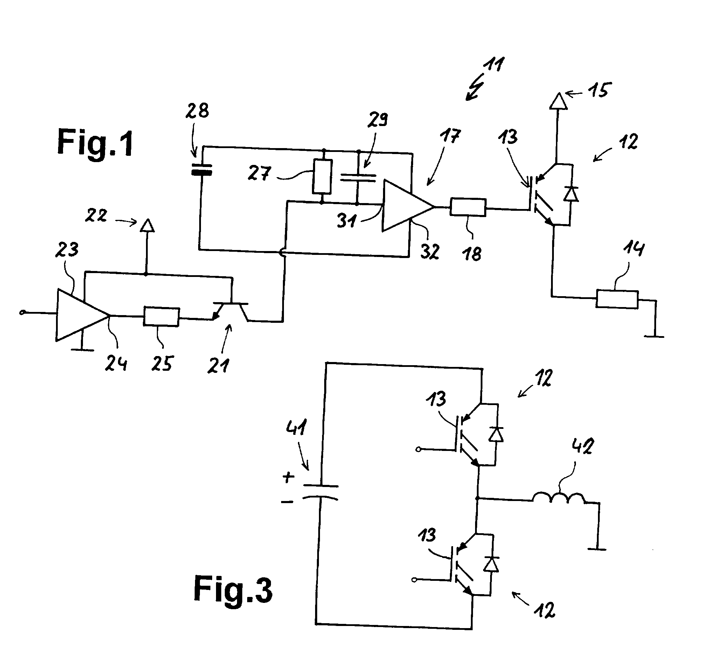

Die Fig. 1 zeigt eine aus drei Blöcken bestehende Schaltungsanordnung 11 als Treiber für einen Leistungsschalter 12, hier ein IGBT. Dieser Leistungsschalter 12 schaltet eine Last 14 an eine Spannung 15. Die Treiber-Schaltungsanordnung 11 ist über einen Widerstand 18 mit einem Gatter 13 des Leistungsschalters 12 verbunden.

Der erste Block der Schaltungsanordnung weist einen Signal- bzw. NPN-Transistor 21 auf, dessen Basis mit dem positiven Anschluß einer Spannungsversorgung 22 verbunden ist, die eine Schaltlogik 23 versorgt. Deren Signalausgang 24 ist über einen Festwiderstand 25 an den Emitter des NPN-Transistors 21 angeschlossen. Der Kollektor des NPN-Transistors 21 ist mit dem Eingang eines frei flottierenden Treibers 17 sowie über einen Widerstand 27 mit dem positiven Anschluß einer frei flottierenden Hilfsstromversorgung 28 verbunden.

Der zweite Block besteht aus einem Stromdetektor- bzw. Totzeit-Glied mit dem Widerstand 27 sowie einem dazu parallel geschalteten Kondensator 29, die beide an den positiven Anschluß der frei flottierenden Hilfsstromversorgung 28 angeschlossen sind. Diese kann eine Gleichspannung von beispielsweise 15 Volt aufweisen.

Der dritte Block besteht im wesentlichen aus dem frei flottierenden Treiber 17, der von der Hilfsstromversorgung 28 betrieben wird. Er verstärkt das Signal, das das mit seinem Eingang 31 verbundene Stromdetektor- bzw. Totzeit-Glied erzeugt und aktiviert das Gatter 13 des Leistungsschalters 12. Der Treiber 17 umfaßt einen invertierenden Spannungskomparator und eine Trennstufe, wobei der invertierende Eingang 31 mit dem Kollektor des Transistors 21 und sein negativer Eingang 32 mit einer Referenzschwelle bzw. dem negativen Anschluß der Hilfsstromversorgung 28 verbunden ist.

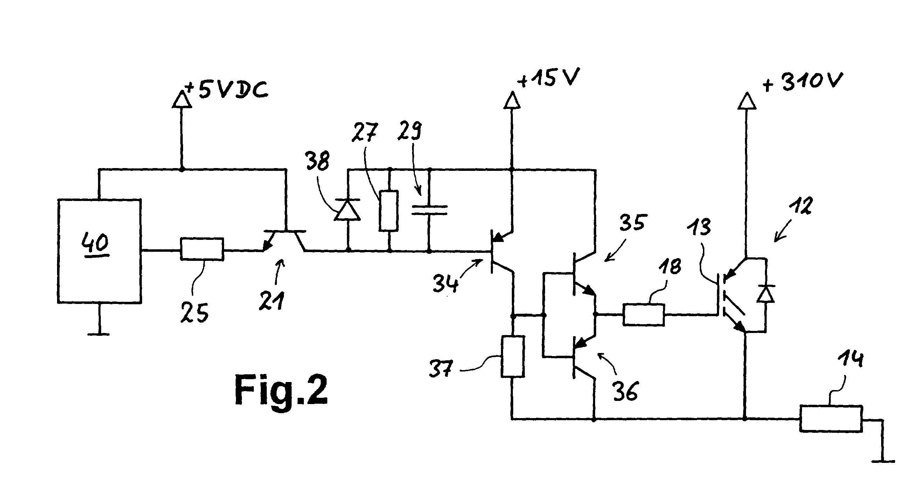

Die Fig. 2 zeigt eine Schaltungsanordnung 11, bei der der frei flottierende Treiber 17 durch ein konkretes Beispiel dargestellt ist. Ein PNP-Transistor 34 in Emitterschaltung weist einen Pull-Down-Widerstand 37 am Kollektor auf, der gegen die Last 14 gelegt ist. An den Kollektor sind die Basen eines NPN- und eines PNP-Transistors 35, 36 in Emitterfolgeschaltung gelegt, deren Emitter miteinander verbunden sind. Der Kollektor des NPN-Transistors 35 ist an eine positive Spannung mit ca. 15 Volt gelegt. Der Kollektor des PNP-Transistors 36 ist an die Last 14 gelegt. Die verbundenen Emitter der Emitterfolgeschaltung steuern über den Widerstand 18 das Gatter 13 des Leistungsschalters 12 an. Die Basis des PNP-Transistors 34 bildet den Eingang der Schaltung für den Treiber und ist mit dem NPN-Transistor 21 verbunden. Als Stromdetektor- bzw. Totzeit-Glied sind der Widerstand 27 und der Kondensator 29 wie obenstehend geschaltet. Die Treiberschaltung weist darüber hinaus eine schnelle Diode 38 auf, die parallel zu dem Kondensator 29 mit ihrer Kathode an die 15 V-Spannung gelegt ist. Die Schaltlogik 23 ist in Fig. 2 durch einen Mikrokontroller 40 dargestellt.

Fig. 3 schließlich zeigt eine Brückenschaltung zweier Leistungsschalter 12 an einer Gleichspannungsversorgung 41 mit hoher Spannung an. Dabei ist der Kollektor des ersten Leistungsschalters 12 mit dem positiven Anschluß der Gleichspannung verbunden, sein Emitter mit dem Kollektor des zweiten Leistungsschalters und dessen Emitter wiederum mit dem negativen Anschluß der Gleichspannung. An der Verbindung des Emitters mit dem Kollektor hängt eine zu betreibende induktive Spule 42 als Last. Die Leistungsschalter 12 sind mit vorstehend beschriebenen Schaltungsanordnungen über ihre Gatter 13 angesteuert.

### FUNKTION

Die Funktion soll beispielhaft anhand von Zahlenbeispielen erläutert werden. Ein Signaltransistor, der ein NPN-Transistor 21 sein kann, wird von der Firma Philips unter der Bezeichnung BF 487 hergestellt. Wird ein Low-Signal von der Schaltlogik 23 an den NPN-Transistor 21 gelegt, wird dieser leitend und ein konstanter Emitterstrom fließt. Unter der Annahme, daß die Spannungsversorgung 22 etwa 5 Volt beträgt und der Festwiderstand 25 einen Wert von 2,2 kOhm aufweist, beträgt der Emitterstrom 2 mA. In der gezeigten Konfiguration entspricht der Kollektorstrom im aktiven Betrieb in etwa dem Emitterstrom (99% davon für einen β-Faktor von 100), wobei der Strom unabhängig von der an dem Kollektor anliegenden Spannung ist, solange diese niedriger ist als V_{cbo} des Transistors.

Der Kollektorstrom von 2 mA fließt, wenn eine Spannung, die deutlich höher als die Emitterspannung von 5 Volt ist, am Kollektor anliegt. In dem beschriebenen Beispiel liegt der Bereich zwischen 15 Volt und 325 Volt, sowohl vor als auch nach dem Einschalten des Leistungsschalters 13.

Der Kollektorstrom fließt über den Widerstand 27 und den Kondensator 29, wobei er einen zunehmenden Spannungsabfall am Eingang des Treibers 17 erzeugt. Dieser wird nach einer gewissen Verzögerung aktiv, welche von der Eingangsschaltschwelle und den Werten für den Widerstand 27 und den Kondensator 29 abhängt. Z.B. kann bei einer Schaltschwelle von -0.6 der Wert für den Widerstand 27 1 kOhm und für den Kondensator 29 4,7 nF betragen, woraus eine Verzögerung von 2 Mikrosekunden resultiert.

Wird der Treiber 17 aktiv, steuert er über den Widerstand 18 das Gatter 13 an und der Leistungsschalter 12 schaltet durch. Auf oben beschriebene Weise kann durch Anlegen eines logischen Low-Signals an den Signal-Transistor 21, evtl. durch einen Mikrokontroller 40, der Leistungsschalter 12 durchgeschaltet werden.

## Patentansprüche

1. Schaltungseinrichtung mit einer Pegelveränderungseinrichtung und einem Treiber (17) für einen elektronischen Leistungsschalter (12), insbesondere einen IGBT oder Leistungs-MOS-Transistor, mit dem eine Last (14) betrieben wird, insbesondere eine Induktionsspule (42), dadurch gekennzeichnet, daß sie einen Signal-Transistor (21) aufweist, dessen Basis mit dem positiven Anschluß einer Spannungsversorgung (22) für ein logisches Eingangssignal verbunden ist, wobei das logische Eingangssignal von einer Schaltlogik (23) über einen Festwiderstand (25) an den Emitter des Signal-Transistors (21) gegeben wird, und wobei dessen Kollektor über einen Widerstand (27) mit dem positiven Anschluß einer Hilfsstromversorgung (28) verbunden ist.

2. Schaltungseinrichtung nach Anspruch 1, dadurch gekennzeichnet, daß sie einen Spannungskomparator und einen Treiber (17) als Verstärker aufweist, die beide an die Hilfsstromversorgung (28) angeschlossen sind, wobei der Eingang (31) des Treibers (17) mit dem Kollektor des Signal-Transistors (21) verbunden ist.

3. Schaltungseinrichtung nach Anspruch 1 oder 2, dadurch gekennzeichnet, daß der Treiber (17) frei flottierend ist, wobei er den Leistungsschalter (12) ansteuert, insbesondere mit dessen Gatter (13) verbunden ist.

4. Schaltungseinrichtung nach einem der vorhergehenden Ansprüche, dadurch gekennzeichnet, daß die Hilfsstromversorgung (28) frei flottierend ist.

5. Schaltungseinrichtung nach einem der vorhergehenden Ansprüche, dadurch gekennzeichnet, daß die Schaltlogik (23) ein Baustein mit negativer Logik ist, wobei sie vorzugsweise in CMOS-Technologie aufgebaut ist, insbesondere ein Mikrokontroller (40) ist.

6. Schaltungseinrichtung nach Anspruch 5, dadurch gekennzeichnet, daß der Signal-Transistor (21) durch ein über den Festwiderstand (25) an seinen Emitter gegebenes LOW-Signal der Schaltlogik (23) aktivierbar ist.

7. Schaltungseinrichtung nach einem der vorhergehenden Ansprüche, dadurch gekennzeichnet, daß sie wenigstens paarweise angeordnet ist um jeweils zwei gleiche Leistungsschalter (12) als Brücke anzusteuern, die über eine Gleichspannungsquelle (41) gelegt sind, wobei der Kollektor des ersten Leistungsschalters mit dem positiven Anschluß der Gleichspannungsquelle verbunden ist, sein Emitter mit dem Kollektor des zweiten Leistungsschalters und dessen Emitter mit dem negativen Anschluß der Gleichspannungsquelle vebunden ist.

8. Schaltungseinrichtung nach Anspruch 2, dadurch gekennzeichnet, daß der Treiber (17) einen PNP-Transistor in Emitterschaltung mit einem Pull-Down-Widerstand (37) am Kollektor aufweist, wobei der Kollektor mit den Basen zweier komplementärer NPN- und PNP-Transistoren (35, 36) in Emitterfolgeschaltung verbunden ist.

9. Schaltungseinrichtung nach einem der vorhergehenden Ansprüche, dadurch gekennzeichnet, daß der Verstärker einen Kondensator (29) und eine Diode (38) aufweist, deren Kathode mit dem positiven Anschluß einer Spannungsversorgung verbunden ist, wobei die Spannungsversorgung insbesondere gegen Erde geht.
